(19) Europäisches Patentamt
European Patent Office
Office européen des brevets

(11) **EP 4 553 893 A1**

(12) **EUROPEAN PATENT APPLICATION**
published in accordance with Art. 153(4) EPC

(43) Date of publication:
14.05.2025 Bulletin 2025/20

(21) Application number: 23853840.9

(22) Date of filing: 07.03.2023

(51) International Patent Classification (IPC):
*H01L 23/367* (2006.01)

(52) Cooperative Patent Classification (CPC):
H01L 23/367; H01L 23/473

(86) International application number:
PCT/CN2023/080067

(87) International publication number:
WO 2024/036923 (22.02.2024 Gazette 2024/08)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 15.08.2022 CN 202210977062

(71) Applicant: ZTE CORPORATION
Shenzhen, Guangdong 518057 (CN)

(72) Inventors:
• ZHOU, Xiaodong
Shenzhen, Guangdong 518057 (CN)
• LIU, Fan
Shenzhen, Guangdong 518057 (CN)
• TAO, Cheng
Shenzhen, Guangdong 518057 (CN)

(74) Representative: Ziebig Hengelhaupt Intellectual
Property Attorneys
Patentanwaltskanzlei PartGmbB
Leipziger Straße 49
10117 Berlin (DE)

(54) **COLD PLATE AND ELECTRONIC DEVICE**

(57) Provided in the present disclosure are a cold plate and an electronic device. The cold plate comprises a plate body, fin groups and a first liquid replenishment assembly, wherein a fluid cavity is formed inside the plate body, the plate body is provided with a liquid intake cavity and a liquid output cavity respectively formed on two sides in the working-medium flow direction of the fluid cavity, and the liquid intake cavity and the liquid output cavity are both in communication with the fluid cavity; a plurality of fin groups are arranged in the fluid cavity at intervals in the working-medium flow direction, each fin group comprises a plurality of fins arranged at intervals in a first direction, and the fins in every two adjacent fin groups are alternately arranged in the first direction, the first direction being perpendicular to the working-medium flow direction; and the first liquid replenishment assembly comprises a first main branch pipe and a first side branch pipe, which are in communication with each other, the first main branch pipe being in communication with the liquid intake cavity, and the first side branch pipes being located on the side of the fluid cavity in the first direction and being in communication with the fluid cavity.

FIG.1

**Description**

CROSS-REFERENCE TO RELATED APPLICATIONS

The present disclosure claims priority to the Chinese Patent Application CN202210977062.2, filed on August 15, 2022, entitled "Cold Plate and Electronic Device", the entire contents of which are incorporated by reference into the present disclosure.

TECHNICAL FIELD

The present disclosure relates to the field of communications, and in particular, to a cold plate and an electronic device.

BACKGROUND

The high heat flux density of microelectronic chips leads to a sudden rise in operating temperature, resulting in significant thermal stress on the chip surface, which seriously threatens chip performance, stability, and service life. Micro-nano processing technology is employed to create micro-nano heat transfer structures on substrates made of different materials, which are then encapsulated to form microchannels for heat exchange through single-phase forced convection and flow boiling.

However, within the microchannels, the boundary layer continuously thins as the working medium flows along the flow direction, ultimately leading to deteriorated heat transfer and posing a technical problem of a large temperature difference on the chip surface.

SUMMARY

The present disclosure provides a cold plate and an electronic device to at least solve the technical problem in the related art that there is a large temperature difference on the chip surface.

According to one embodiment of the present disclosure, there is provided a cold plate, including a plate body, a fluid cavity being formed inside the plate body, wherein the plate body is provided with a liquid intake cavity and a liquid output cavity respectively formed on two sides in a working-medium flow direction of the fluid cavity, and the liquid intake cavity and the liquid output cavity are both in communication with the fluid cavity; a plurality of fin groups, arranged in the fluid cavity at intervals in the working-medium flow direction, wherein each fin group includes a plurality of fins arranged at intervals in a first direction, and the fins in every two adjacent fin groups are alternately arranged in the first direction, the first direction being perpendicular to the working-medium flow direction; and one or more first liquid replenishment assemblies, each including a first main branch pipe and one or more first side branch pipes, which are in communication with the first main branch pipe, the first main branch pipe being in communication with the liquid intake cavity, and the one or more first side branch pipes being located on the side of the fluid cavity in the first direction and being in communication with the fluid cavity.

According to another embodiment of the present disclosure, there is provided an electronic device including: the cold plate of the foregoing embodiment, and an electronic component mounted on the plate body.

BRIEF DESCRIPTION OF DRAWINGS

The accompanying drawings described herein are included to provide a further understanding of the disclosure and constitute a part of this disclosure, and illustrative embodiments of the disclosure and their description are used to explain the disclosure and do not constitute an unduly limitation to the disclosure. In the drawings:

FIG. 1 is an exploded structural schematic diagram of a cold plate according to the present disclosure;
FIG. 2 is a structural schematic diagram of a plate body in the cold plate according to the present disclosure;
FIG. 3 is an axonometric diagram of the plate body in the cold plate according to the present disclosure;
FIG. 4 is a structural schematic diagram of a first liquid replenishment assembly in the cold plate according to the present disclosure;
FIG. 5 is a partial enlarged diagram of a portion B in FIG. 4;
FIG. 6 is a first partial axonometric diagram of the cold plate according to the present disclosure;
FIG. 7 is a second partial axonometric diagram of the cold plate according to the present disclosure;
FIG. 8 is a cross-sectional diagram taken along A-A in FIG. 7;
FIG. 9 is a structural schematic diagram of a lid in the cold plate according to the present disclosure; and

FIG. 10 is an axonometric diagram of the lid in the cold plate according to the present disclosure.

Reference signs:

1, plate body; 101, fluid cavity; 102, liquid intake cavity; 103, liquid output cavity; fin; 3, first liquid replenishment assembly; 301, first main branch pipe; 302, first side branch pipe; 303, first liquid replenishment port; 4, lid; 5, second liquid replenishment assembly; 501, second main branch pipe; 502, second side branch pipe; S1, heat source region; S2, channel region; S3, core region.

DETAILED DESCRIPTION

Hereinafter, the present disclosure will be explained in detail with reference to the accompanying drawings and in conjunction with embodiments. It should be noted that the embodiments in the present disclosure and the features in the embodiments may be combined with each other without conflict.

It should be illustrated that the description and claims of the present disclosure and the terms in the above drawings "first", "second", etc. are used to distinguish similar objects, without having to describe a specific order or precedence order.

The high heat flux density of microelectronic chips leads to a sudden rise in operating temperature, resulting in significant thermal stress on the chip surface, which seriously threatens chip performance, stability, and service life. Micro-nano processing technology is employed to create micro-nano heat transfer structures on substrates made of different materials, which are then encapsulated to form microchannels for heat exchange through single-phase forced convection and flow boiling. Compared with conventional channels, microchannels offer advantages such as large specific surface area, high heat transfer efficiency per unit area, strong heat treatment capability, and miniaturization, thereby meeting the demand of microelectronic devices for compact and miniature heat exchange equipment.

However, within the microchannels, the boundary layer continuously thins as the working medium flows along the flow direction, ultimately leading to deteriorated heat transfer and posing a technical problem of a large temperature difference on the chip surface, and further affecting uniformity in chip surface temperature.

Embodiment 1

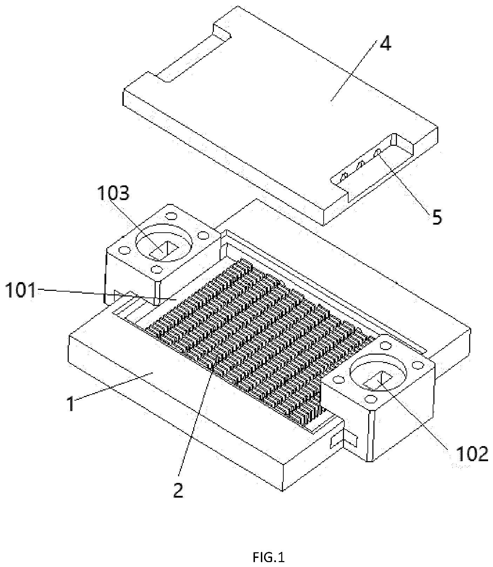

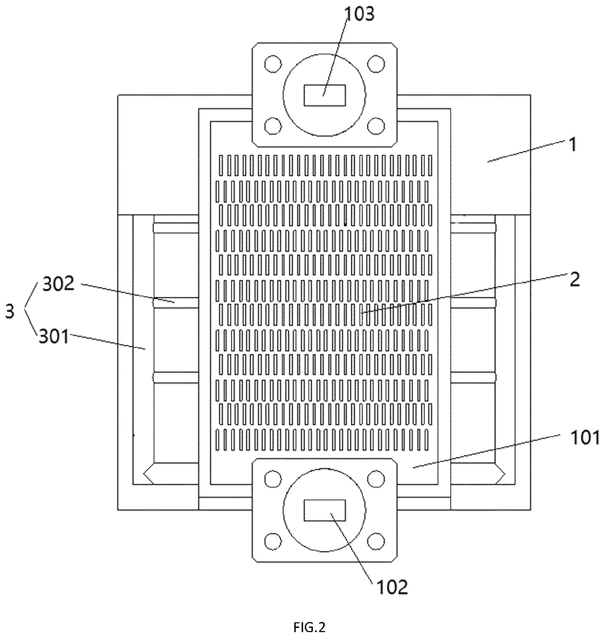

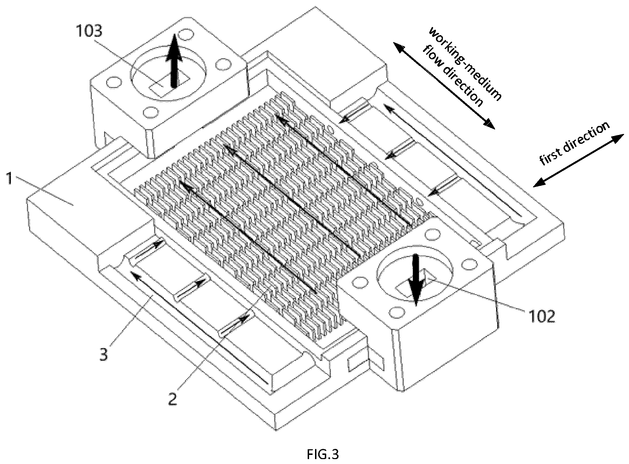

A cold plate is provided in the present embodiment, FIG. 1 is an exploded structural schematic diagram of a cold plate according to the present disclosure; FIG. 2 is a structural schematic diagram of a plate body 1 in the cold plate according to the present disclosure, FIG. 3 is an axonometric diagram of the plate body in the cold plate according to the present disclosure, as shown in FIGS. 1-3, the cold plate includes a plate body 1, fin groups, and one or more first liquid replenishment assemblies 3, a fluid cavity 101 is formed inside the plate body 1, the plate body is provided with a liquid intake cavity 102 and a liquid output cavity 103 respectively formed on two sides in the working-medium flow direction of the fluid cavity 101, and the liquid intake cavity 102 and the liquid output cavity 103 are both in communication with the fluid cavity 101. A plurality of fin groups are arranged in the fluid cavity 101 at intervals in the working-medium flow direction, each fin group includes a plurality of fins 2 arranged at intervals in a first direction, and the fins 2 in every two adjacent fin groups are alternately arranged in the first direction, the first direction being perpendicular to the working-medium flow direction. The first liquid replenishment assembly 3 includes a first main branch pipe 301 and one or more first side branch pipes 302, which are in communication with the first main branch pipe, the first main branch pipe 301 being in communication with the liquid intake cavity 102, and the one or more first side branch pipes 302 being located on the side of the fluid cavity in the first direction and being in communication with the fluid cavity 101.

By alternatively arranging the fins 2, the boundary layer is constantly disrupted during the flow of the working medium within the fluid cavity 101, thus increasing the frequency of disturbance cycles. This inhibits bubble coalescence within the fluid cavity 101, enhances turbulent heat transfer, and suppresses core dryout. Furthermore, in combination with the setup of the one or more first liquid replenishment assemblies 3, liquid replenishment is conducted through the one or more first side branch pipes 302 from the sides of the fins 2, reducing the dryness accumulation effect along the length of the channel and achieving temperature and flow uniformity. Consequently, the problem of significant temperature differences on the chip surface is addressed, ensuring uniformity in chip surface temperature.

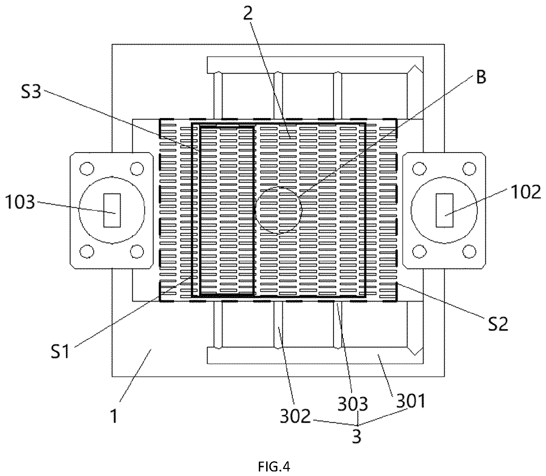

Referring to FIG. 4, in some embodiments, the first liquid replenishment assembly 3 is provided as a cavity structure formed inside the plate body 1. In an exemplary embodiment, the first uniformity replenishment assembly 3 is formed on one side of the plate body 1 in a first direction, in which the first liquid replenishment assembly 3 and the fluid cavity are arranged adjacently, so as to ensure that the working medium in the first side branch pipe 302 can be replenished in the first direction towards the fins 2 in the fluid cavity, achieving the effect of temperature and flow uniformity in the working-medium flow direction of the working medium from the liquid intake cavity 102 to the liquid output cavity 103.

In an exemplary embodiment, the first liquid replenishment assembly 3 may also be provided as an external pipe structure connected to the plate body 1. In an exemplary embodiment, the first main branch pipe 301 and the one or more first side branch pipes 302 are welded or plugged to the plate body 1, so that the first main branch pipe 301 communicates with the liquid intake cavity 102 and the one or more first side branch pipes 302 communicate with the fluid cavity 101. In this arrangement, the pipe diameters of the first main branch pipe 301 and the one or more first side branch pipes 302 may not be limited by the thickness of the plate body 1, and the pipe diameters of the first main branch pipe 301 and the one or more first side branch pipes 302 may be flexibly adjusted by mounting and dismounting to indirectly adjust the liquid replenishment amount to meet the requirements of different operating conditions.

Referring to FIGS. 2-4, in some embodiments, an axial direction of the first side branch pipe 302 is arranged in parallel with the first direction, so that the fluid in the first side branch pipe 302 can impact in the first direction towards the fins 2, this allows the fluid in the first side branch pipe 302 to replenish perpendicularly to the sides of the fins 2, so that there is a greater scouring action between the fluid and the sides of the fins 2, increasing heat exchange capacity, reducing heat exchange temperature rise, and ensuring inlet flow stability and inlet uniformity.

In some embodiments, the fins 2 are evenly spaced in the first direction to facilitate fabrication of the fins 2 in the fluid cavity. Furthermore, a shape of the orthographic projection of the fins 2 along a direction perpendicular to the height direction thereof may be rectangular, circular, rhombic or triangular, etc. In the present disclosure, a rectangular shape is adopted, and in order to ensure the heat exchange capacity of the working medium in the fluid cavity, the length direction of the rectangular shape is parallel to the flow direction of the working medium, and the width direction of the rectangular shape is parallel to the first direction, and the effect of the resistance of the fins 2 on the working medium is reduced.

Referring to FIGS. 2 and 3, in an exemplary embodiment, a shape of the orthographic projection of the fluid cavity 101 along a direction perpendicular to the height direction of the fins 2 is adapted to the shape of the fins 2, when the shape of the orthographic projection of the fins 2 is rectangular, the shape of the orthographic projection of the fluid cavity is also rectangular, and the length direction of the fluid cavity is a direction parallel to the working-medium flow direction, and the width direction of the fluid cavity is a direction parallel to the first direction.

In an exemplary embodiment, the first main branch pipe 301 includes a first section and a second section in communication, an end of the first section remote from the second section communicates with a liquid inlet, and the second section is adapted to communicate with the first side branch pipe 302. To ensure smooth flow in the fluid replenishment path of the first liquid replenishment assembly 3, the axial direction of the first section is parallel to the first direction, and the axial direction of the second section is parallel to the working-medium flow direction.

In an exemplary embodiment, a plurality of first side branch pipes 302 are provided at intervals in the working-medium flow direction. The arrangement of the plurality of first side branch pipes 302 addresses the dryness accumulation of the working medium along the length of the fluid cavity 101, ensuring that the performance of the working medium meets predefined requirements when it flows into the liquid output cavity 103. It should be noted that "a plurality of" in the context of the plurality of first side branch pipes 302 refers to two or more pipes. The specific number of first side branch pipes 302 and the spacing between them in the working-medium flow direction need to be selected and determined by technicians in the field based on factors such as the total length of the fluid cavity 101, the set operating quality, and the variation rule of heat transfer coefficient of the working medium with the quality. This embodiment does not impose restrictions on these aspects. As an example, for an R134a medium, the distance between adjacent first side branch pipes 302 is 6-10mm, ensuring that the operating quality of the medium remains below 0.2 and that the heat transfer performance is stable under conditions of adequate fluid replenishment. Similarly, the diameters of the plurality of first side branch pipes 302 can be identical, partially identical, or completely different, and technicians in the field can make selections based on actual operating conditions. In an exemplary embodiment, where the diameters of the first side branch pipes 302 are completely different, the diameters of the first side branch pipes 302 gradually increase in the working-medium flow direction. At this point, the diameters of the first side branch pipes 302 can increase regularly or change irregularly, and the specific variation process needs to be selected based on specific operating conditions and target temperatures.

In an exemplary embodiment, the fluid cavity 101 is arranged at an intermediate position of the plate body 1, two first liquid replenishment assemblies 3 are arranged, and the two first liquid replenishment assemblies 3 are symmetrically arranged on both sides of the fluid cavity 101. By symmetrically arranging the two first liquid replenishment assemblies 3 on two sides of the fluid cavity 101, and flushing the fins 2 along the first direction through the first side branch pipes 302 in the two first liquid replenishment assemblies 3, a symmetrical liquid replenishment effect is achieved, further ensuring the effect of temperature and flow uniformity. At the same time, liquid replenishment is performed through both sides of the fluid cavity 101, so that the disturbance capability is enhanced and the heat exchange efficiency is improved.

Referring to FIGS. 3-4, in some embodiments, the first side branch pipe 302 communicates with the fluid cavity 101 through a first liquid replenishment port 303 and a central axis of the first liquid replenishment port 303 is located at a gap between two adjacent fin groups. With this arrangement, the fluid can disturb more regions, ensuring the heat transfer effect.

In an exemplary embodiment, the diameter of the first liquid replenishment port 303 is greater than the length of the gap in the working-medium flow direction, and the diameter of the first liquid replenishment port 303 is less than the length of the fin 2 in the working-medium flow direction. When the diameter of the first liquid replenishment port 303 is too small, the resistance of the fluid is too large; when the diameter of the first liquid replenishment port 303 is too large, the pressure difference is too small to significantly affect the flow distribution pattern, and the effect of temperature and flow uniformity is poor.

Referring to FIGS. 1-4, in some embodiments, there are corresponding heat source region S1 and channel region S2 within the fluid cavity 101, wherein the heat source region S1 is a region of the fluid cavity 101 corresponding to a heat-conducting portion of an electronic component, i.e., the effective heat generating area that the heat generating region of the electronic component can conduct. The cold plate provided in this embodiment is suitable for pump-driven two-phase liquid cooling systems, which is serially connected in a secondary circuit and installed on the surface of the electronic component with high heat flux density, functioning as an evaporator or heat sink. In an exemplary embodiment, the electronic component is installed on the lower surface of the plate body 1, which is also referred to as the thermal interface. In an exemplary embodiment, to ensure the heat transfer effect, the material of the thermal interface can be liquid metal, thermally conductive silicone, or soldering processes, etc. Similarly, the material of the plate body 1 can be aluminum alloy, copper, or a special ceramic, etc.

The boundaries of the channel region S2 in the first direction are the two edges of the fluid cavity 101, while the boundaries of the channel region S2 in the working medium flow direction are the two edges of the plurality of fin groups. In the first direction, two edges of the channel region S2 and two edges of the heat source region S1 coincide, or the distance between the edge of the channel region S2 and the adjacent edge of the heat source region S1 does not exceed a first preset dimension. This arrangement ensures that the entire region of the heat source region S1 is in a state of flow boiling heat transfer, preventing the working medium from experiencing non-heat-transfer conditions during flowing, which could cause flow losses. When the length of the channel region S2 in the first direction is much greater than the length of the heat source region S1, there will be ineffective flow regions on the fins 2, resulting in reduced effective flow and heat transfer efficiency. Additionally, resistance in the heat source region S1 corresponding to the middle in the first direction will repel the working fluid located in the middle towards the two sides along the first direction, causing the flow to disperse towards the two edges. This can lead to issues of non-uniform heat dissipation from the heat source, causing dry spots to appear in the core region S3 and deterioration in boiling heat transfer.

It should be noted that the core region S3 refers to the mid-rear portion of the heat source region S1 in the liquid flow region. The core region S3 has the furthest diffusion range of the working medium and the greatest temperature gradient. Along the working-medium flow direction, the quality gradually increases, and the tension gradually decreases, leading to a stronger evaporation effect and potentially causing dry spots. In this disclosure, by limiting the distance between the edge of the channel region S2 and the heat source region S1 in the first direction, the occurrence of the aforementioned issues can be effectively avoided. This prevents the working medium from bypassing and escaping to ineffective regions, thereby addressing the issue of boiling heat transfer. In an exemplary embodiment, the first preset dimension is 2mm.

In an exemplary embodiment, the distance between the edge of the channel region S2 and the adjacent edge of the heat source region S1 in the working-medium flow direction does not exceed a second predetermined dimension, the second predetermined dimension being 4 mm.

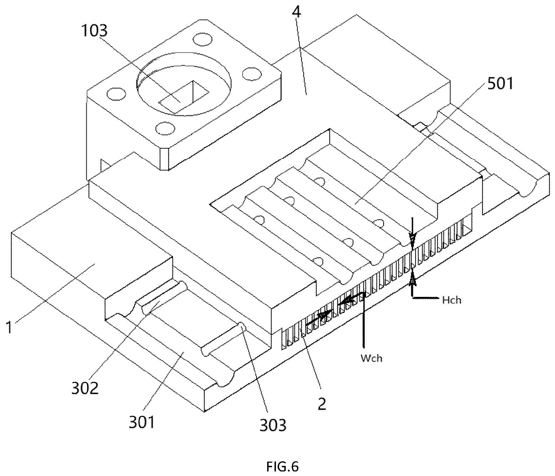

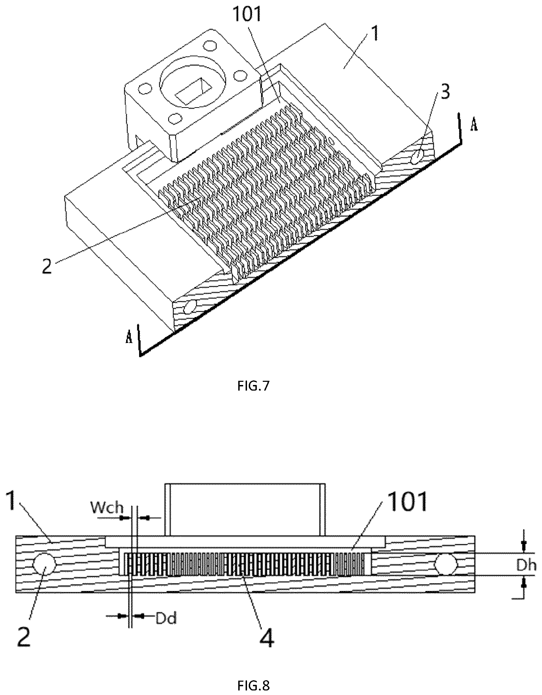

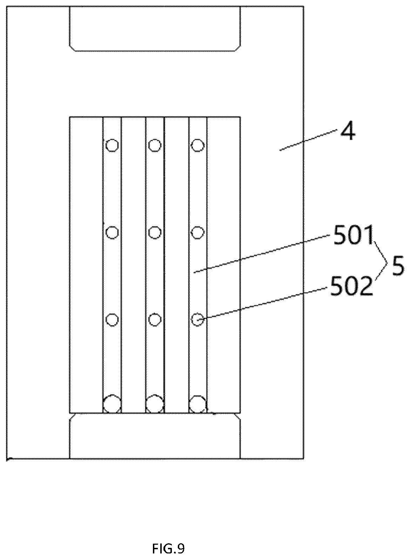

Referring to FIGS. 6-9, in some embodiments, the top of the fluid cavity 101 is provided with an opening, the cold plate further includes a lid 4 for covering the opening, the lid 4 is provided with second liquid replenishment assemblies 5, the second liquid replenishment assembly 5 includes: a second main branch pipe 501 and second side branch pipes 502, the second main branch pipe 501 is used for communicating with the liquid output cavity 103; one end of the second side branch pipe 502 communicates with the second main branch pipe 501, the other end of the second side branch pipe 502 communicates with the fluid cavity 101, and the second side branch pipes 502 are arranged extending in the height direction of the fins 2. The second side branch pipes 502 flush the fins 2 in the height direction of the fins 2, to further secure temperature and flow uniformity of the working medium in the fluid cavity 101, thus improving the wettability of the liquid-phase working medium in the middle rear section in the working-medium flow direction in the fluid cavity 101, and maximizing the uniformity of heat dissipation of the cold plate.

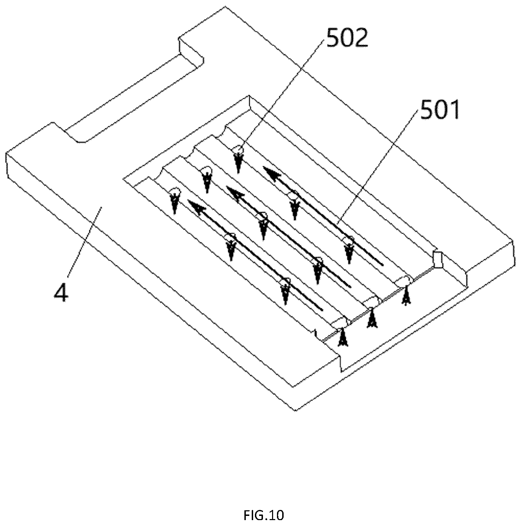

With reference to FIG. 10, in an exemplary embodiment, a plurality of second side branch pipes 502 are provided at intervals in the working-medium flow direction. The arrangement of the plurality of second side branch pipes 502 addresses the dryness accumulation of the working medium along the length of the fluid cavity 101, ensuring that the performance of the working medium meets predefined requirements when it flows into the liquid output cavity 103. It should be noted that "a plurality of" in the context of the plurality of second side branch pipes 502 refers to two or more pipes. The specific number of second side branch pipes 502 and the spacing between them in the working-medium flow direction need to be selected and determined by technicians in the field based on factors such as the total length of the fluid cavity 101, the set operating quality, and the variation rule of heat transfer coefficient of the working medium with the quality. This embodiment does not impose restrictions on these aspects.

In an exemplary embodiment, a plurality of second liquid replenishment assemblies 5 are arranged at intervals in the first direction, and the heat exchange effect is further enhanced by the arrangement of the plurality of second liquid replenishment assemblies 5. It should also be noted that the plurality of second liquid replenishment assemblies 5 refer to two or more groups. In actual use, those skilled in the art need to choose to adopt an adapted cold plate structure according to actual operating requirements.

In an exemplary embodiment, the second side branch pipe 502 communicates with the fluid cavity 101 through a second liquid replenishment port, the central axis of the second liquid replenishment port is parallel to the height direction of the fins 2, so that the fluid passing into the fluid cavity 101 through the second liquid replenishment port can pass perpendicular to the surface of the fins 2 for replenishment, ensuring uniformity of flow distribution between the parallel microchannels.

In an exemplary embodiment, the lid 4 and the plate body 1 may be joined by brazing or stir welding, the lower surface of the lid 4 and the wall of the fluid cavity 101 enclose a heat exchange chamber for the flow of the working medium, and the fin groups are provided in the heat exchange chamber to ensure the reliability of the heat exchange process.

Referring to FIGS. 6-8, in some embodiments, the staggered arrangement of the fins 2 divides the fluid cavity into a plurality of microchannels, the distance between two adjacent fins 2 in the first direction is a channel width $W_{ch}$, and the ratio between the height $H_{ch}$ of the fluid cavity 101 and the channel width $W_{ch}$ is less than 10: 1. By adjusting the channel width $W_{ch}$ to adjust the resistance of the fluid within the fluid cavity 101, while limiting the ratio of the height $H_{ch}$ of the fluid cavity 101 to the channel width $W_{ch}$ to guarantee problems of disturbance periodicity, it is determined that the resistance is minimized to guarantee the heat exchange effect in the case of an adaptive disturbance effect.

In an exemplary embodiment, the height of the fins 2 is less than or equal to the height of the fluid cavity 101 to ensure reliability of arrangement of the fins 2 within the fluid cavity 101. In an exemplary embodiment, the height of the fins 2 is less than 3 mm, and when the height of the fins 2 is higher, there is a weakening effect on the top of the fins 2, and the temperature rise of the fluid in the fluid cavity 101 decreases, resulting in a decrease in the heat exchange efficiency.

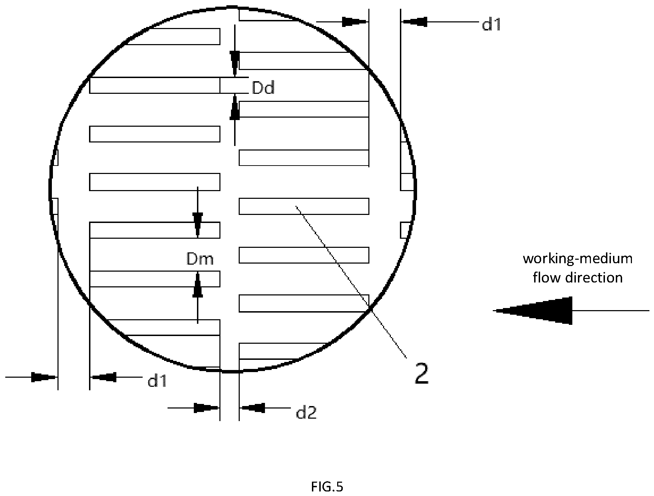

With reference to FIG. 5, in an exemplary embodiment, the length of the fins 2 in the working-medium flow direction is 6-10 times the thickness of the fins 2 in the first direction. When the length of the fins 2 in the working-medium flow direction is too long, it will cause the fluid disturbance effect to fall short of expectations, failing to effectively peel off the boundary; when the length of the fins 2 in the working-medium flow direction is too small, the resistance is too large, the temperature rise is increased, and the pressure drop is increased.

Referring to FIGS. 5-8, in an exemplary embodiment, the selection of specific dimensions for the fins 2 is shown, and the specific dimensions include the length of the fins 2 in the working-medium flow direction, the width of the fins 2 in the first direction, the height of the fins 2, as well as the lateral and longitudinal arrangement spacings of the alternatively arranged fins 2. The lateral arrangement spacing of the fins 2 refers to the distance between two adjacent fins 2 in the first direction, and the longitudinal arrangement spacing of the fins 2 refers to the distance between adjacent fin groups. Different materials and processing techniques for the fins 2 may result in different manufacturing limits for the dimensions of the fins 2. For instance, when the fins 2 are made of aluminum alloy and processed using numerical control machining, the minimum distance between two adjacent fins 2 in the first direction is approximately 0.4mm-0.5mm, and the minimum thickness of the fins 2 in the first direction is approximately 0.4mm. When the fins 2 are made of copper and prepared using numerical control machining, the minimum thickness of the fins 2 in the first direction is approximately 0.2mm. Therefore, to ensure a higher fin efficiency, the lateral arrangement spacing of the fins 2 is generally set to 3-4 times the thickness of the fins 2 in the first direction, and the longitudinal arrangement spacing of the fins 2 is generally set to 1-2 times the thickness of the fins 2 in the first direction.

With reference to FIG. 3, in some embodiments, the distances between a fin group and the two adjacent fin groups in the working-medium flow direction are different from each other, so that the flow velocity cycle can be adjusted during the disturbance, thereby increasing the heat exchange effect. As an example, there are three fin groups, which are arranged sequentially as the first group, the second group, and the third group along the working-medium flow direction, a distance between the first group and the second group is a first spacing, a distance between the second group and the third group is a second spacing, i.e., the first spacing and the second spacing are not equal in value; in an exemplary embodiment, the first spacing is greater than the second spacing. When the fin groups are provided with more than three groups, the spacing values may be set periodically, i.e., there are five fin groups, which are arranged sequentially as the first group, the second group, the third group, the fourth group, and the fifth group along the working-medium flow direction, the distance between the third group and the fourth group being a third spacing, and the distance between the fourth group and the fifth group being a fourth spacing, i.e., the first spacing is the same value as the second spacing, and the third spacing is the same value as the fourth spacing.

In an exemplary embodiment, the distance between the fin groups at the rear section in the working-medium flow direction is greater than the distance between the fin groups at the front section in the working-medium flow direction, as an example, there are five fin groups, i.e., the values of the first spacing, the second spacing, the third spacing and the fourth spacing are all different from each other, and the third spacing value is greater than the first spacing value and the fourth spacing value is greater than the second spacing value. As the working medium flows in the fluid cavity 101 along its flow direction, its velocity increases progressively. With the rise in velocity, the disturbance frequency of the working medium located in the rear section increases. The situation where the disturbance frequency varies with the flow of the working medium results in the disturbance in the rear section being changing and increasing. Therefore, it is necessary to adjust the distance between adjacent fin groups to regulate the flow velocity cycle and ensure heat transfer efficiency.

To compare the heat transfer performance under two different configurations of the first fluid replenishment assemblies 3 and the heat transfer effect under the structure provided by this disclosure, experimental validation is conducted using the various dimensional parameters of the cold plate provided in Table 1.

Table 1 Cold Plate Related Structural Dimensions

| Type of cold plate | Heat source region S1 area (mm²) | Thickness (mm) | Tooth thickness * tooth height (mm) | Tooth center to center distance (mm) | Total number of fins (pcs) | Total length of fins in working-medium flow | Fluid cavity width in first direction (mm) |
|---|---|---|---|---|---|---|---|
| Solution 1 & Solution 2 | 500 | 1.5 | 0.25 * 2 | 0.75 | 28 fins * 12 groups | 28.5 mm | 22 mm |

Wherein, Solution 1 refers to the configuration where the first fluid replenishment assemblies 3 are formed inside the plate body 1; Solution 2 refers to the configuration where the first fluid replenishment assemblies 3 are formed outside the plate body 1, specifically through an external pipe structure. The thickness refers to the thickness of the plate body 1 located between the fluid cavity 101 and the electronic component. The tooth thickness $D_d$ refers to the thickness of the fins 2 in the first direction. The tooth height $D_h$ refers to the height of the fins 2. The tooth center-to-center distance refers to the center-to-center distance between two adjacent fins 2 in the first direction. The distance between adjacent fins 2 in the first direction is Dm, so the tooth center-to-center distance is the sum of the tooth thickness and the distance between adjacent fins 2. The total number of fins is 28 fins * 12 groups, which means that there are 12 fin groups located within the fluid cavity 101 and arranged at intervals along the working-medium flow direction, with each group having 28 fins arranged at intervals in the first direction. The total length of the fins 2 in the working-medium flow direction is also the length of the channel region S2 in the working-medium flow direction. The width of the fluid cavity 101 in the first direction is also the width of the channel region S2 in the first direction. Additionally, the spacing between adjacent fin groups is periodically arranged, with the distances $d_1$ and $d_2$ set sequentially along the working-medium flow direction as 0.5mm and 0.3mm, respectively.

Therefore, with the fluid cavity 101, the fin groups, and the heat source region S1 of the electronic component remaining unchanged, experimental validation is conducted on the two different configurations of the first fluid replenishment assemblies 3 proposed in Solution 1 and Solution 2. Taking the case where the working medium flowing within the fluid cavity 101 is R134a and the total power consumption of the heat source designed is 1500W as an example, the following experimental data is obtained: the operating conditions are that the quality is 0.2, a corresponding mass flow rate is 1590 kg/(m²s). Moreover, the experimental data results obtained from Solution 1 and Solution 2 are basically consistent. It can be known that during the structural design of the cold plate, the configuration of the first fluid replenishment assembly 3 does not significantly affect the heat transfer effect. Therefore, those skilled in the art can select a more suitable connection method based on different operating conditions. Additionally, the aforementioned experimental data also indicates that under the aforementioned constraints on the dimensional configuration of the fins 2, a relatively optimal operating condition quality can be achieved, which can meet the enhanced heat transfer requirements in scenarios with high heat flux densities and realize high heat dissipation capacity with low flow resistance.

Referring to FIGS. 3 and 6, in some embodiments, after determining the corresponding dimensions of the fins 2, in order to secure the heat exchange performance of the cold plate, in addition to performance verification through specific experiments, synchronization verification can be performed through corresponding expressions. The portion between two adjacent fins 2 in the first direction and extending in the working-medium flow direction is referred to as a microchannel, and the hydraulic diameter of the channel is calculated as follows:

$$D_h = \frac{2W_{ch}H_{ch}}{W_{ch} + H_{ch}}$$ ----- Expression 1

Wherein, $D_h$ represents the hydraulic diameter of a single channel, the unit is meter (m); $W_{ch}$ represents the channel width, which is the distance between the surfaces of two adjacent fins 2 in the first direction, the unit is meter (m); and $H_{ch}$ represents the channel height, which is the height between the lower surface of the cover body 4 and the lower surface of the fluid cavity 101, i.e., the height value of the fluid cavity 101, the unit is meter (m). $W_{ch}$ of 0.5mm and $H_{ch}$ of 2mm are substituted into the aforementioned expression to yield a calculated $D_h$ of 0.8mm.

However, the distinction between microchannels and macrochannels is determined by a characteristic number known as the confinement number (Co). The calculation method for the confinement number is as follows:

$$Co = \left[ \frac{\sigma}{g \, (\rho_l - \rho_g) \, D_h^{\,2}} \right]^{1/2}$$ ---- Expression 2

Wherein, $D_h$ represents the hydraulic diameter of a single channel, the unit is meter (m); $\sigma$ represents the surface tension, the unit is N/m; $\rho_l$ represents the density of the liquid phase, the unit is kg/m$^3$; $\rho_g$ represents the density of the gas phase, the unit is kg/m$^3$; and g is the gravitational acceleration, the unit is m/s$^2$. The criterion for the confinement number (Co) is defined as follows: when Co is greater than 0.5, the flow state is considered confined; when Co is less than or equal to 0.5, the flow state is considered macroscopic. Hence, it can thus be seen that when Co equals 0.5, it serves as the transition point between macroscopic and confined flow states. Therefore, by substituting Co = 0.5 into Expression 2, the calculated hydraulic diameter $D_h$ of the single channel is also defined as the critical hydraulic diameter Dc.

By way of example, the working medium R134a is taken as an example and the physical parameters of the working medium R134a at 20 degrees Celsius are taken, it can be seen that the surface tension $\sigma$ is $8.6915 \times 10^{-3}$N/m, the liquid phase density $\rho_l$ is 1225.3 kg/m$^3$, the gas phase density $\rho_g$ is 27.78 kg/m$^3$, and the gravity acceleration g is 9.8 m/s$^2$. By substituting the above parameters into Expression 2, the critical hydraulic diameter Dc is 1.72 mm, so the above channels can be regarded as microchannels. It should be noted that, in the absence of experimental data verification under the specific structure, it is suggested that the aforementioned Expressions 1 and 2 are used as methods for determining the microchannel scale of the conventional two-phase working medium.

Furthermore, an analysis of the flow pattern maps for boiling flow in channels for different working media reveals that, for example, the transition from conventional channel flow to transitional flow occurs at a confinement number Co of 0.3-0.4 for working media such as R134a, R236fa, and R245fa. The transition from microchannel flow to transitional flow occurs at a confinement number Co of approximately 1. Therefore, for these working media, transitional flow occurs when the confinement number Co is in the range of 0.3-0.4 to 1. Consequently, for these working media, the method for calculating the microchannel scale should be based on a confinement number Co of 1. The working medium R134a is taken as an example and the physical parameters of the working medium R134a at 20 degrees Celsius are taken, the surface tension $\sigma$ is $8.6915 \times 10^{-3}$N/m, the liquid phase density $\rho_l$ is 1225.3 kg/m$^3$, the gas phase density $\rho_g$ is 27.78 kg/m$^3$, and the gravity acceleration g is 9.8 m/s$^2$. A confinement number Co of 1 is substituted into Expression 2 to yield a critical hydraulic diameter Dc of 0.86 mm. Thus, for the working fluid R134a at a physical property temperature of 20 degrees Celsius, a channel with a single-channel hydraulic diameter $D_h$ of 0.8 mm, calculated using the aforementioned Expression 1, belongs to the microchannel category. If the calculated single-channel hydraulic diameter does not fall within the microchannel scale, the design parameters can be adjusted by modifying the channel width and height, and then the calculations can be performed again following the aforementioned steps to ensure that the single-channel hydraulic diameter falls within the microchannel flow scale.

It should be noted that the larger the confinement number Co, the smaller the microchannel scale, and conversely, the smaller the confinement number Co, the larger the microchannel scale. Under the premise of ensuring heat dissipation capability, the confinement number Co corresponding to the size of the microchannel designed fin 2 should be selected slightly above the critical confinement number Co that represents the upper limit of the microchannel scale. This approach allows for achieving the lowest possible flow resistance and optimal pump power.

In summary, the cold plate provided by the present disclosure improves the problem that the boundary layer of the working medium flowing along the working-medium flow direction is continuously thinned until the heat transfer deteriorates through the fins 2 alternatively arranged in the fluid cavity 101, so that the working medium can enhance turbulence and strengthen local boiling to prevent the formation of dry spots. By replenishing fluid through the first liquid replenishment port 303 from the sides of the fins 2, it reduces the dryness accumulation effect along the length of the channels, achieving temperature or flow compensation to inhibit the explosive growth of bubbles in microchannels. By positioning the central axis of the first liquid replenishment port 303 perpendicular to the surface of the fins 2, it ensures even fluid inflow to the fins 2. The width of the channel region S2 is adjusted according to the width of the heat source region S1 to prevent the working medium in the fluid cavity 101 from bypassing and escaping to ineffective regions. By restricting the aspect ratio of the fins 2, it guarantees the heat transfer fin efficiency and heat exchange efficiency. Therefore, the cold plate structure provided in this disclosure achieves an ultra-high heat dissipation capacity of 300W/cm$^2$ with low flow resistance and a convective heat transfer temperature difference below 30K, and addresses the challenge of highly reliable and stable heat dissipation for current chip structures with dimensions of 22.3mm x 22.3mm.

It can be seen that the cold plate provided by the present disclosure is suitable for scenarios requiring enhanced heat transfer in microchannel configurations under conditions of saturated flow boiling heat transfer with higher heat flux density, specifically referring to scenarios with higher heat flux density greater than 100W/cm$^2$. It is applicable when the heat source is arranged along the working-medium flow direction, and it is suitable for scenarios with stringent requirements on indicators evaluating energy efficiency or noise levels in data centers. Furthermore, this structure is particularly suitable for the design of cold plates for various gas-liquid two-phase working media, and is not limited to refrigerant scenarios. The structure is suitable for other two-phase working media such as ammonia, and the working medium is not limited to liquids. The working media mentioned earlier can be various gas-liquid two-phase working media.

Embodiment 2

Also provided in this embodiment is an electronic device including the cold plate of the previous embodiment and an electronic component, the electronic component being mounted on the plate body 1. The electronic device is used to implement the above-described embodiments and preferred embodiments, which have been described and will not be described in detail.

Through the present disclosure, by alternatively arranging the fins in the first direction, the flowing and heat transfer boundary layers are thinned, turbulence is enhanced, and localized boiling is intensified to prevent the formation of dry spots. Additionally, by replenishing fluid through the first side branch pipes from the sides of the fins, the working medium within the fluid cavity maintains uniform temperature and flow, reducing the dryness accumulation effect along the channel length. This, in turn, addresses the issue of large temperature difference on the chip surface and ensures uniformity in chip surface temperature. Through this disclosure, it is possible to enhance turbulence-induced heat transfer, suppress core dry-out, reduce the dryness accumulation effect along the channel length, ensure the stability and uniformity of fluid intake flow, and achieve high heat dissipation capacity.

The above description is merely preferred embodiments of the present disclosure, and is not intended to limit the present disclosure, and various modifications and changes can be made to those skilled in the art. Any modification, equivalent substitution, improvement, etc. made within the principles of the present disclosure should be included within the scope of protection of the present disclosure.

**Claims**

1. A cold plate, comprising:

   a plate body, a fluid cavity being formed inside the plate body, wherein the plate body is provided with a liquid intake cavity and a liquid output cavity respectively formed on two sides in a working-medium flow direction of the fluid cavity, and the liquid intake cavity and the liquid output cavity are both in communication with the fluid cavity;
   a plurality of fin groups, arranged in the fluid cavity at intervals in the working-medium flow direction, wherein each fin group comprises a plurality of fins arranged at intervals in a first direction, and the fins in every two adjacent fin groups are alternately arranged in the first direction, the first direction being perpendicular to the working-medium flow direction; and
   one or more first liquid replenishment assemblies, each comprising a first main branch pipe and one or more first side branch pipes, which are in communication the first main branch pipe, the first main branch pipe being in communication with the liquid intake cavity, and the one or more first side branch pipe beings located on the side of the fluid cavity in the first direction and being in communication with the fluid cavity.

2. The cold plate of claim 1, wherein an axial direction of the first side branch pipe is arranged parallel to the first direction.

3. The cold plate of claim 1, wherein the fluid cavity is arranged at an intermediate position of the plate body, two first liquid replenishment assemblies are arranged, and the two first liquid replenishment assemblies are symmetrically arranged on both sides of the fluid cavity.

4. The cold plate of any one of claims 1-3, wherein the first side branch pipe communicates with the fluid cavity through a first liquid replenishment port, and a central axis of the first liquid replenishment port is located in a gap between two adjacent fin groups.

5. The cold plate of claim 4, wherein a diameter of the first liquid replenishment port is greater than a length of the gap in the working-medium flow direction, and the diameter of the first liquid replenishment port is less than a length of the fin in the working-medium flow direction.

6. The cold plate of claim 1, wherein the fluid cavity is correspondingly provided with:

a heat source region, the heat source region being a region of the fluid cavity corresponding to a heat-conducting portion of an electronic component; and

a channel region, boundaries of which in the first direction are two edges of the fluid cavity, and boundaries of which in the working-medium flow direction are two edges of the plurality of fin groups; wherein

in the first direction, two edges of the channel region and two edges of the heat source region coincide, or a distance between the edge of the channel region and an adjacent edge of the heat source region does not exceed a first preset dimension.

7. The cold plate of claim 6, wherein the first preset dimension is 2 mm.

8. The cold plate of claim 1, wherein the plate body comprises a cavity body that forms the fluid cavity and a lid that covers the cavity body, the lid having second liquid replenishment assemblies formed thereon, each second liquid replenishment assembly comprising:

a second main branch pipe for communicating with the liquid output cavity; and

second side branch pipes having one end communicating with the second main branch pipe and the other end communicating with the fluid cavity, the second side branch pipe extending in a height direction of the fin.

9. The cold plate of claim 1, wherein the fins are equally spaced in the first direction, a distance between two adjacent fins in the first direction is a channel width, and an ratio of a height of the fluid cavity to the channel width is less than 10: 1.

10. The cold plate of any one of claims 5-9, wherein the fins have a height of less than 3 mm.

11. An electronic device, comprising:

the cold plate of any one of claims 1-10, and

an electronic component mounted on the plate body.

FIG.1

FIG.2

103

working-medium
flow direction

first direction

1

3

2

102

FIG.3

FIG.4

FIG.5

working-medium
flow direction

FIG.6

FIG.7

FIG.8

FIG.9

FIG.10

## INTERNATIONAL SEARCH REPORT

| International application No. |
|---|
| **PCT/CN2023/080067** |

### A. CLASSIFICATION OF SUBJECT MATTER

H01L 23/367(2006.01)i

According to International Patent Classification (IPC) or to both national classification and IPC

### B. FIELDS SEARCHED

Minimum documentation searched (classification system followed by classification symbols)

IPC:H01L

Documentation searched other than minimum documentation to the extent that such documents are included in the fields searched

Electronic data base consulted during the international search (name of data base and, where practicable, search terms used)

DWPI; CNABS; CNTXT; ENTXT; ENTXTC; CNKI; IEEE: 冷板, 翅片, 补液, 流体, 腔, 流动, 进, 出, 连通, 管, cool, plate, fin, add, liquid, fluent, chamber, drift, in, out, connect

### C. DOCUMENTS CONSIDERED TO BE RELEVANT

| Category* | Citation of document, with indication, where appropriate, of the relevant passages | Relevant to claim No. |
|---|---|---|
| X | CN 113840516 A (NANCHANG HUAQIN ELECTRONIC TECHNOLOGY CO., LTD.) 24 December 2021 (2021-12-24) <br> description, paragraphs [0033]-[0056], and figures 1-6 | 1-11 |
| X | CN 104776652 A (SUZHOU KUNTU THERMAL CONTROL SYSTEMS CO., LTD.) 15 July 2015 (2015-07-15) <br> description, paragraphs [0040]-[0059], and figures 1-11 | 1-11 |
| A | US 2019212076 A1 (ASIA VITAL COMPONENTS CO., LTD.) 11 July 2019 (2019-07-11) <br> entire document | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 April 2023** | **28 April 2023** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| | | | International application No. |
|---|---|---|---|
| | | | **PCT/CN2023/080067** |

| Patent document cited in search report | | | Publication date (day/month/year) | Patent family member(s) | | | Publication date (day/month/year) |
|---|---|---|---|---|---|---|---|
| CN | 113840516 | A | 24 December 2021 | None | | | |
| CN | 104776652 | A | 15 July 2015 | CN | 104776652 | B | 01 September 2017 |
| US | 2019212076 | A1 | 11 July 2019 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210977062